# EUROPEAN PATENT APPLICATION

(11) **EP 4 276 477 A1**
(43) Date of publication of application: **15.11.2023**
(21) Application number: 22173267.0
(22) Date of filing: 13.05.2022
(51) Int. Cl.: G01R 19/165

(54) **SELF-POWERED ALTERNATING CURRENT INDICATOR**

(71) Applicant: HARTING Electric Stiftung & Co. KG, 32339 Espelkamp (DE)
(72) Inventor: MIHAIU, Ilie Mircea, 550018 Sibiu (RO)
(74) Representative: Dennemeyer & Associates S.A.

(57) **Abstract**

Self-powered current indicator (11) for indicating different levels of the value of an alternating current, in particular of a secondary current, exiting a current source (14), in particular a current transformer, the current indicator (11) comprising an electronic circuitry (4) connectable to the current source (14) and supplied by the alternating current, wherein the electronic circuitry (4) comprises one or more circuitry branches (13) including each at least a switching element (6), said electronic circuitry (4) being configured to deviate a circuit current flowing in the electronic circuitry (4) in said one or more circuitry branches (13) upon activating the switching element (6) based on the value of the alternating current.

## Description

The present invention relates to a self-powered current indicator for indicating different levels of the value of an alternating current, in particular of a secondary current, exiting a current source, in particular a current transformer. Also, the present invention relates to a system comprising said self-powered current indicator.

The measurement of an alternating current can be carried out in different ways. When dealing with very high currents, the use of current transformers (CTs) could be the best solution. CTs are inductive sensors consisting of a primary coil, a magnetic core, and a secondary coil. Essentially, a high current is transformed to a lower current using a magnetic carrier, thus very high currents can be measured safely and efficiently. In most CTs, the primary coil has very few turns, while the secondary coil has many more turns. This ratio of turns between the primary and secondary coil determines how much the magnitude of the current load is stepped down. The alternating current detected by the primary coil produces a magnetic field in the core, which induces a current in the secondary coil. This current is thus converted to the output of the sensor.

Generally, a current transformer is used to transmit current information signal to a measuring instrument, protective device, or similar apparatus. Therefore, in order to have a visual indication of the measured alternating current, connecting cables are needed to connect for example an AC ammeter and/or an additional power source is required to supply for example a dedicated electronic device. However, in some circumstances, this could be inefficient and not cost-effective, especially when a very accurate measurement of the current is not required and an easy manageable device is desired.

Examples of the present disclosure seek to address or at least alleviate the above problems.

In a first aspect, there is provided a self-powered current indicator for indicating different levels of the value of an alternating current, in particular of a secondary current, exiting a current source, in particular a current transformer, the current indicator comprising an electronic circuitry connectable to the current source and supplied by the alternating current, wherein the electronic circuitry comprises one or more circuitry branches including each at least a switching element, said electronic circuitry being configured to deviate a circuit current flowing in the electronic circuitry in said one or more circuitry branches upon activating the switching element based on the value of the alternating current.

In a second aspect there is provided a system, the system comprising a current source including an induction module coupable to an electric cable, through which a primary current flows, said induction module being configured to induce a secondary current from said primary current, wherein the primary current is an alternating current; and a self-powered current indicator according to the first aspect, wherein the current indicator is connectable to the current source for indicating different levels of the value of the primary current flowing in the electric cable, the current indicator being supplied by the secondary current.

Other aspects and features are defined in the appended claims.

Examples of the disclosure may provide a current indicator and a system that can display the alternating current flowing through an AC cable without the need of an external power and with the possibility of a remote communication.

Examples of the disclosure will now be described by way of example only with reference to the accompanying drawings, in which like references refer to like parts, and in which:
Figure 1A is a schematic representation of a system according to an example;
Figure 1B is a schematic representation of a self-powered current indicator according to an example;
Figure 2 is an electronic circuit of a system and of a self-powered current indicator according to an example with four indication elements;
Figure 3 is an electronic circuit of a system and of a self-powered current indicator according to another example with four indication elements;
Figure 4 is an electronic circuit of a system and of a self-powered current indicator according to a further example with four indication elements and
Figure 5 is an electronic circuit of a system and of a self-powered current indicator according to an example with ten indication elements.

A self-powered current indicator is disclosed. In the following description, a number of specific details are presented in order to provide a thorough understanding of the examples of the disclosure. It will be apparent however to a person skilled in the art that these specific details need not be employed in order to practise the examples of the disclosure. Conversely, specific details known to the person skilled in the art are omitted for the purposes of clarity in presenting the examples.

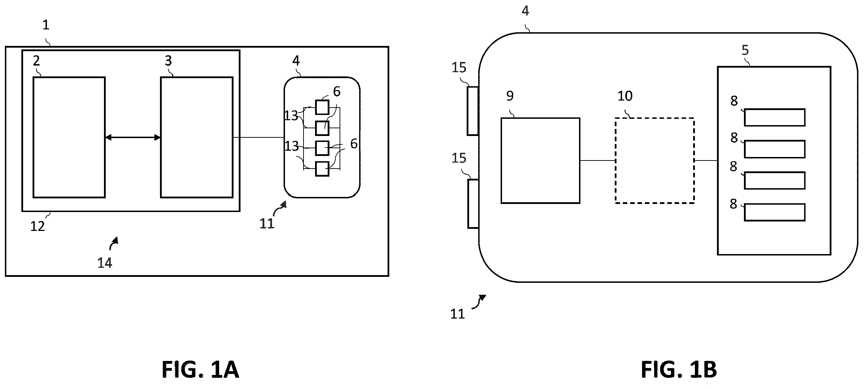

Figure 1A illustrates a schematic representation of a system 1 a current indicator 11 used for indicating the value of the current exiting a current source 14. In particular, the current source 14 can be a current transformer including an induction module 12 that can be coupled to an electric cable, in particular an AC cable. The induction module 12 comprises a magnetic core 2 and a secondary coil 3 coupled to the magnetic core 2. The induction module 12, in particular the magnetic core 2, is coupled to an electric cable, through which a primary current flows. The induction module 12 is configured to induce a secondary current from the primary current, wherein the primary current is an alternating current. In other words, the magnetic core 2 and the secondary coil 3 are part of a current transformer. In this way, the system 1 and the current indicator 11 can offer an indication of the current level flowing in the electric cable coupled to the induction module 12.

The self-powered indicator 11 is connected to the current source 14 and in particular to the induction module 12, and more in particular to the output of the secondary coil 3, and is configured to indicate the value of the secondary current induced by the induction module 12. As shown in the figure, the self-powered indicator 11 comprises an electronic circuitry 4 directly coupled to the secondary coil 3. The electronic circuity 4 comprises a plurality of circuity branches 13 having each a switching element 6. Figure 1A schematically shows four circuity branches 13 arranged in parallel. The electronic circuitry 4 is configured to deviate the circuit current in the circuitry branches 13 upon activating the switching element 6 based on the value of the alternating current, i.e. the secondary current. With circuit current is intended the electrical current flowing in the electronic circuitry 4. As it will be explained below, the circuit current can be a direct current as a result of a AC/DC transformation of the alternating current, in particular secondary current exiting the current source, i.e. the current transformer. Therefore, the different values of the circuit current flowing in the electronic circuitry 4 are directly related to the different levels of the alternating current exiting the current source 14.
In examples, the electronic circuitry 4 comprises an indication unit 5 for indicating a level of the secondary current. The level can be a proportional value of the alternating (secondary) current. In particular, the indication unit 5 comprises at least an indication element 8 formed by at least a light emitting element 7, in particular a light emitting diode. Thanks to the indication elements 8 of the indication unit 5, the current indicator 11 is able to indicate the amount, or level, of the secondary current. Since the secondary current is proportional to the primary current, the current indicator 11 is consequently configured to indicate the level of the primary current as well. As a matter of fact, based on the value of the secondary current, one or more switching elements 6 can be activated and the circuit current is deviated through the circuitry branches 13 passing in a corresponding light emitting elements 7, thereby providing an indication of the current passage by an activation of said light emitting elements 7. The higher the number of the switching elements 6 activated, i.e. the higher the number of light emitting elements 7 activated, the bigger the amount of the circuit current flowing in the electronic circuitry 4, i.e. the bigger the level of the primary current. As shown in the figure, the indication unit 5 can comprise a plurality of indication elements 8 connected one subsequent of the other, i.e. in parallel. With a low circuit current, the first light emitting element 7 is lighted up. As the circuit current value increases, the other indicators 8 are activated and the other light emitting elements 7 are lighted up. It is noted that the light emitting element 7 is lighting as a function of the current so that by increasing the amount of current flowing in the light emitting element 7, the light intensity increases. Therefore, the light intensity of the light emitting element 7 is also an indication of the amount of circuit current.

In examples, the electronic circuitry 4 comprises a plurality of circuitry branches 13, at least a part of the switching elements 6 of the circuit branches 13 being configured to allow the passage of the circuit current through one or more light emitting elements 7 connected to said switching elements 6, when said circuit current exceeds a reference threshold current value. The reference threshold current can depend on the different electronic element forming the electronic circuitry 4 of the current indicator and can be selected in advance. For example, the reference threshold current can be related to the optimum value of direct current flowing in each light emitting element 7.

For example, the light emitting elements 7 can be LEDs having each an optimum current value of 5 mA (i.e. for a LED having a maximum permitted current for example of 25 mA, the optimum value of direct current can be 5 mA or 10 mA. This is selected for the safety working operation of the LED). The reference threshold current value can be for example 5 mA or a multiple of this value. Following the induction effect of the induction module 12, the secondary current exits the secondary coil 3 and can flow in the electronic circuitry 4 as a circuit current. It is noted that before flowing in the indication elements 8 the alternating current can be AC/DC transformed so that the circuit current is a direct current. When this threshold current value is reached, a switching element 6 is switched on and the circuit current is deviated in one of the subsequent circuit branches 13 containing a LED 7. The activation of the switching element 6 indicates that the circuit current is higher than the threshold value, i.e. 5 mA or more. When the value of the current is further increased, for example is two times the reference threshold current value, another switching element 6 can be activated which in turn can divert the circuit current to another circuit branch 13 comprising another LED 7. In other words, the current indicator 11, in particular the indication unit 5, represents a LED bar indicating the current value flowing in the electronic circuitry 4. Since the secondary current is proportional to the primary current of the induction module 12, the current indicator 11, in particular the indication unit 5, represents a LED bar indicating the value, or rather the level, of the primary current.

In examples, the light emitting element 7 is configured to light up as a function of the circuit current quantity flowing therein. As mentioned above, the light emitting element 7 lights up as long as a current flows. However, for very small currents, the light intensity can be very low. The light intensity increases by increasing the current value. In case of a LED, the maximum intensity is achieved when the current achieves the optimum current of said LED. For example, if the electronic circuitry 4 comprises four indication elements 8 containing each a light emitting element 7 (LED) having an optimum current value of 5 mA, the maximum current flowing through the series of LEDs 7 would be 20 mA with a secondary voltage drop of 3V. With a value of 20 mA for the secondary current, all LEDs 7 light up, that is the rated current for the electronic circuit. Accordingly, the reference rated current value would be in this case 20 mA. If the current increase from 0 mA to 5 mA, the light intensity of a first LED 7 also increase from zero to the value of light intensity correspond to 5 mA. The rest of the LEDs 7 (e.g., second, third and fourth LED) do not light up. When the current exceeds 5 mA, the first switching element 6 is activated and the a circuit current higher than 5 mA passes through the second LED 7. Again, the lighting of second LED 7 increases as a function of the difference between actual current and 5 mA. The light intensity of the second LED 7 increases from 0 mA to the maximum intensity corresponding to 5 mA. In other words, if a circuit current of about 7.5 mA is flowing in the electronic circuitry 4, the first LED 7 will light up completely at the maximum intensity, whereas the second LED will light up with almost half intensity. As long as the circuit current does not exceed 10 mA, the circuit current is deviated in only the first two indication elements 8 including the first and second LED 7 (5 mA for each LED). If the circuit current is higher than 10 mA the second switching element 6 is activated and the supplementary current (i.e. the current exceeding 10 mA) passes through the third LED 7, and so on.

In examples, the level of the secondary current displayed by the indication unit 5 is a fraction of a reference rated current value or is equal to said reference rated current value. When the circuit current is less than 5 mA, no LED 7 is lighted up at maximum intensity. As a matter of fact, only the first LED 7 is slightly lighted up. If the circuit current increases from 5 mA to 10 mA the first LED 7 lights up at the maximum intensity and the second LED 7 lights up as a function of the current. If the current increases from 10 mA to 15 mA another LED 7 lights up, and so on. This LED-based current indicator 11 having four indication elements 8, i.e. four switching elements 6 connected to four LEDs 7, can display for example current values of 25%, 50%, 75% or 100% of the rated current value. Accordingly, based on the light intensity of the LED bar on the current indicator 11 it is possible to estimate if the circuit current is lower than 25%, is 25%, is between 25% and 50%, is 50%, is between 50% and 75%, is 75%, is between 75% and 100%, or is 100% (or more) of the rated current value. By selecting the value of series resistance of the LED 7 it is possible to select a linear or nonlinear variation of the intensity of the lighting LEDs 7 form 0% to 100%.

In examples, at least one switching element 6 is configured to deviate the circuit current to the ground when said circuit current exceeds a reference rated current value. In this way, a protection to the overcurrent through the LEDs 7 is ensured. In this configuration, the current source, i.e. the current transformer, is maintained to low voltage. Based on the example described above, this situation occurs when the circuit current exceeds for example 20 mA.

The switching elements 6 can be any electronic component able to deviate the current in one or more circuit branches 13. In examples, at least one switching element 6 comprises a bipolar transistor or a MOSFET. The switching element 6 can comprise for example complementary bipolar transistors (NPN and PNP). Since the threshold voltage (0,6V for bipolar transistors) varies with temperature, the percentage of the displayed current can varied with temperature. In this case, it is useful to use transistor arrays. Transistor arrays consist on many transistors made on the same chip and the threshold voltage for all transistors varies with temperature in the same way. In this mode, we can obtain a partial compensation of the threshold voltage with temperature.

In order to convert the alternating current coming from the induction module 12, the electronic circuitry 4 further comprises a rectifying unit 9 connectable between the current source 14, i.e. the induction module 12, and the indication unit 5, Advantageously, the rectifying unit 9 can be in particular a diode bridge. Additionally, the electronic circuitry 4 can comprise a filtering unit 10 connectable between the rectifying unit 9 and the indication unit 5. The filtering unit 10 serves to eliminate any component of the alternating current. Advantageously, the filtering unit 10 can be an inductor filter or L-filter.

As shown in figure 1B, the alternating current coming from the current source 14, i.e. from the induction module 12, first passes through the rectifying unit 9 and then through the filtering unit 10. In this way, the indication unit 5 is provided with a DC current. The figure shows the filtering unit 10 with dashed lines, meaning that the filtering unit 10 is not essential for the correct functioning of the self-powered indicator 11. Accordingly, the alternating current coming from the current source 14, i.e. from the induction module 12, first passes through the rectifying unit 9 and then directly reaches the indication unit 5.

To connect the current indicator 11 to the current source 14, the current indicator 11 is provided with a connecting junction 15. As shown in figure 1B, the connecting junction 15 can comprise for example two terminals that can be attached to the output terminals of the current source 14.

As mentioned above, the current source 14 can be a current transformer including the induction module 12 that comprises a magnetic core 2 and a secondary coil 3 coupled to the magnetic core 2. To protect the current transformer and electronic parts in the electronic circuitry 4, the secondary coil 3 can be always an output closed circuit.
As an example, the secondary current can range from 0 A to a maximum value of 1 A. In other words, as the primary current increases from 0 A to a maximum value , the secondary current can increase from 0 A to 1 A. However, other current transformation ratio can be considered such as 100 A/25 mA, 100 A/33.3 mA, 400 A/66.6 mA, 500 A/166 mA, or 800 A/160 mA. The current indicator 11 can be configured based on the value of the output current and the number of turns in the secondary coil 3. In other words, for designing the current indicator 11, it is necessary first to know the maximum secondary current, for example 100mA, when the primary current is 100A or 200A. Then, it is necessary to know how many steps of the final percentage are selected. For example, for 10 steps, it is possible to set up the lighting LED for each 10mA in secondary winding and also 10% of the primary current.

In order to ensure a remote communication of the data provided by the current indicator 11, the system 1 can further comprise a digital wireless module.

Advantageously, the current indicator 11 can be a separated device that can be attached to a current source 14 to obtain an indication of the current level exiting the current source 14. By suitably connecting the electronic circuitry 4 to the current source 14, i.e. to a portion of the current source 14, the indication elements 8 can offer an information regarding the level of the alternating current exiting the current source 14 without the need of an external power source. Accordingly, the current indicator 11 can comprise a connecting junction 15 to connect the electronic circuitry 4 to the current source 14. For example, the connecting junction 15 can comprise one or more connecting terminals that can be directly attached to the output terminal of the current source 14. In case the current source 14 is a current transformer, the connecting terminals can be attached to the secondary coil 3 of the current transformer. In a different configuration, the connecting junction 15 can include at least a portion of the secondary coil 3 and/or at least a portion of the magnetic core 2 of the current transformer, so that the current indicator 11 can be easily and quickly used to combine the at least portion of the secondary coil 3 and/or the at least portion of the magnetic core 2 with a remaining portion of the secondary coil 3 and/or of the magnetic core 2, respectively, and can be laid around an AC cable to have an indication of the current flowing in said cable.

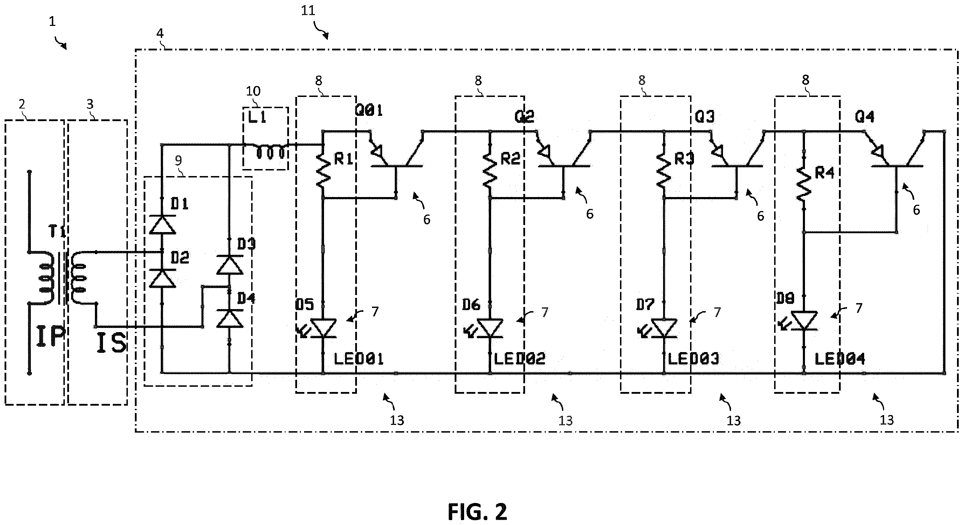

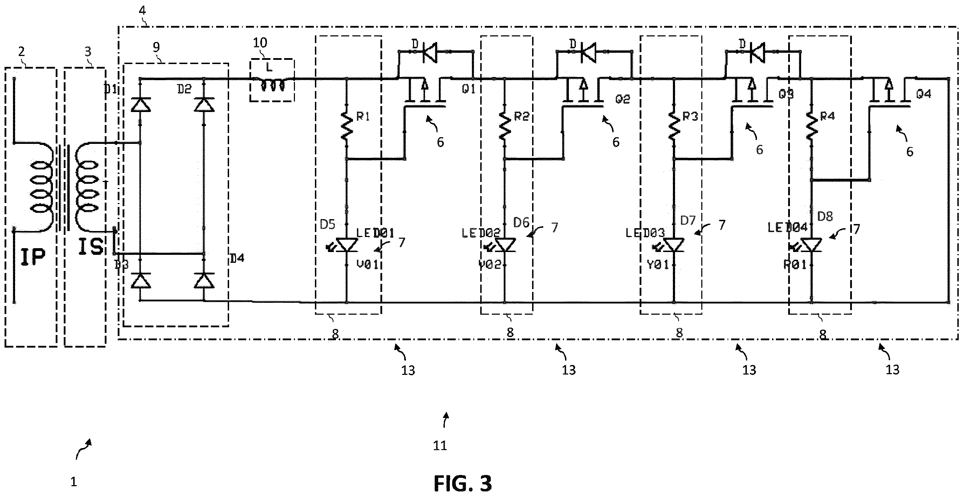

Figures 2 and 3 illustrate two circuit configurations for the system 1 and the current indicator 11. In particular, figure 2 shows a basic schematic circuit of an indication unit 5 having bipolar transistors as switching elements 6, whereas figure 3 shows a basic schematic circuit of an indication unit 5 having MOSFET transistors as switching elements 6.

In both configurations, the system 1 comprises a magnetic core 2 coupable to an electric cable, through which a primary current (IP) flows. A secondary current (IS) is induced by the primary current (IP) on a secondary coil 3 coupled to the magnetic core 2. An electronic circuitry 4 forming the current indicator 11 is connected to the secondary coil 3. The secondary coil 3 is directly connected to a rectifying unit 9 formed by a diode bridge of four diodes (D1-D4). The diode bridge 9 is then connected to an inductance L forming an L filter 10 that is inserted between the rectifying unit 9 and a load formed by a plurality of (in particular four) circuit branches 13 having each an indication element 8 comprising a resistance (R1-R4), a transistor (Q1-Q4) and a LED (D5-D8). Based on the different nature of the transistor used, the switching element 6 can have additional electrical components. Since the output of the current transformer must be always in short circuits, the secondary coil 3 of the current transformer is an output closed circuit.

Advantageously, since the electronic circuitry 4 is supplied by the secondary current induced in the secondary coil 3, the current indicator 4 can operate without supply voltage. Also, this indicator can be coupled to a current transformer as an additional module when it is necessary to obtain an indication of the value of the alternating current flowing in a AC cable.

The configurations of figures 2 and 3 show the use of only four branches 13 and therefore four LEDs that are considered enough for indicating a correspondence percentage of the nominal current, i.e. 25%, 50%, 75% or 100%. However, the number of branches 13 can be increased to any values to display the fine variation of the primary current. As a matter of fact, a different number of indication elements 8 and consequently a different number of switching elements 6 and LEDs 7 can be considered. For example, the indication unit 10 can comprise five, eight or ten indication elements 8 comprising each a LED 7. Accordingly, the current indicator 11 would be a LED bar with five, eight or ten LEDs 7.

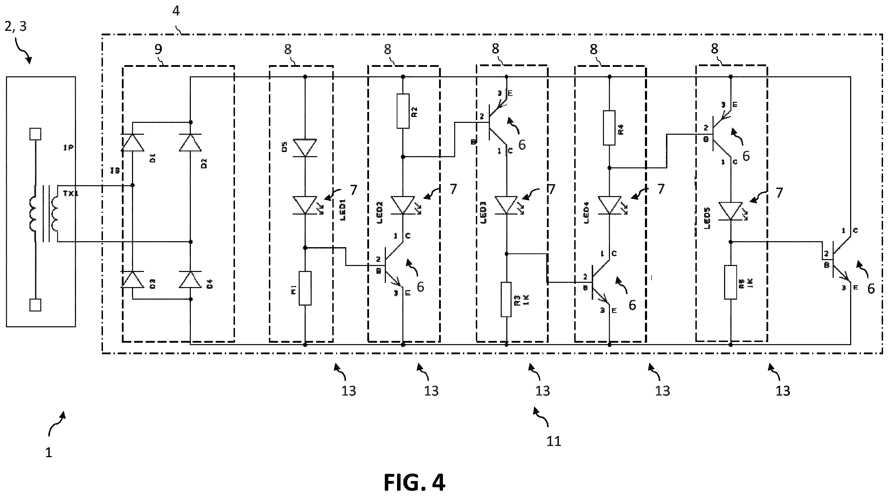

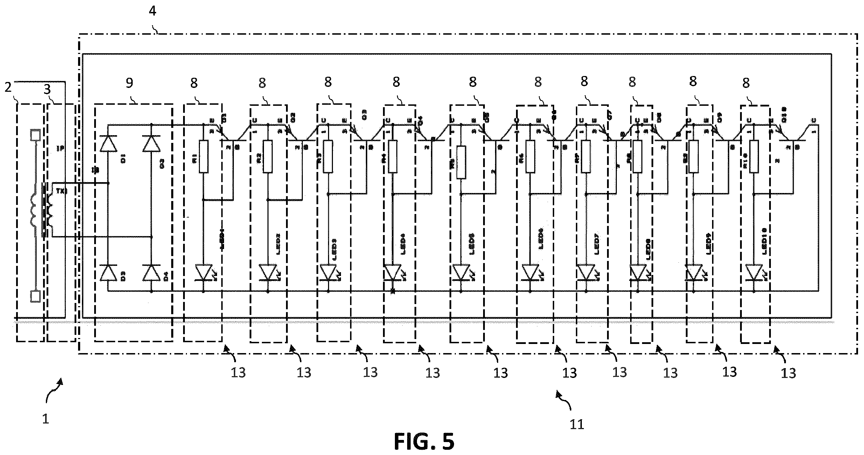

Figure 4 shows a basic schematic circuit with an indication unit 5 having five indication elements 8. Also, the electronic circuitry 4 comprises complementary bipolar transistors NPN and PNP transistors as switching elements 6. On the other hand, figure 5 shows a configuration, wherein the indication unit 10 comprises ten indication elements 8. The functioning of the current indicator 11 of figures 4 and 5 is the same as that shown in figures 2 and 3. It is noted that differently from the circuits of figures 2 and 3, in the electronic circuitry 4 of figures 4 and 5 there is no filtering unit 10, i.e. inductor filter, between the rectifying unit 9 and the first indication element 8. The filtering unit (10) can be added to each circuit, with four, five, or ten LEDs. As a matter of fact, the filtering unit (10) assures a smooth variation of the current but for the low frequency (50Hz) the inductance value must be greater to assure a constant value of the current. For a large value of the filtering inductance, the response time for current variation increases.
In case of five or ten LEDs 7, the reference rated current value (i.e. secondary current) can be 25 mA or 50 mA, respectively. If five LEDs are used the percentage variation of the primary current, can increase with 20% for each supplementary LED 7. If ten LEDs are used, the percentage variation of the primary current, can increase with 10% for each supplementary LED 7. Depending on the types of the LEDs 7, a current value can be displayed at a distance, as a percentage of the rated current. It is noted that the reference rated current value is a function of the maximum output AC current of the current transformer, the numbers of LEDs and the maximum chosen DC current for each LED. The present current indicator 11 is useful for current transformers with the maximum secondary current 1A, because the 5A output current is too bigger for the LEDs. By choosing 1A as secondary current and 10 LEDs, each LED must have a 100mA optimum current. It is useful to choose the current transformer with 500mA, 200mA or smaller for the secondary current, so that the step of the current for 10 LEDs can be 50mA or 20mA as usual values.

It is pointed out that the output of a classic current transformer is a variable AC current or a variable AC, small voltage. For example, a current transformer with a current ratio of 200/1, has an output AC current of 1A, if the primary current is 200A. The output AC current is obtained if the secondary winding is shorted, wherein the burden resistance is very low (a shunt resistance). An important feature of a CT is the electrical power that this can provide to the secondary winding, i.e., the VA parameter. It is known that if the output power increase, the accuracy decrease. In other words, a current transformer must always have a low voltage at the output. If the output is a current, the shunt resistance is very low, i.e. smaller than 1 Ohm. If the output is voltage, the burden resistance is also low but smaller than 10 Ohm.

By coupling the present current indicator 11 to a current transformer, the situation in the burden resistance could be different since the burden resistance is variable. First of all, a certain voltage is required to control the LEDs or light emitting elements (7), and this voltage must be bigger than the threshold voltage of the LEDs (2V....4V). For the switching elements, a threshold voltage (0,6V for bipolar transistors or Vth (1V...2V) for MOSFET) of these elements is necessary. The output voltage for the secondary winding is between 4V and 5V as a function of the threshold voltage of the LED. If it is supposed an output voltage of 4V, for the current transformer, and the output current is variable as a function of the primary current, the burden resistance is variable, for example 4V/5mA=0,8 kOhm, for the 5mA LED current. The output voltage remains constant and the burden resistance decrease for 10 mA to 0,4 kOhm and decrease as a function of the output current. The output power of the current transformer is variable. However, it is necessary that it always remains smaller than VA parameter of the current transformer for a specified accuracy.

Although a variety of techniques and examples of such techniques have been described herein, these are provided by way of example only and many variations and modifications on such examples will be apparent to the skilled person and fall within the spirit and scope of the present invention, which is defined by the appended claims and their equivalents.

### Reference Signs

- 1: System
- 2: Magnetic core
- 3: Secondary coil
- 4: Electronic circuitry
- 5: Indication unit
- 6: Switching element
- 7: Light emitting element
- 8: Indication element
- 9: Rectifying unit
- 10: Filtering unit
- 11: Current indicator
- 12: Induction module
- 13: Branch
- 14: Current source
- 15: Connecting junction

## Claims

1. Self-powered current indicator (11) for indicating different levels of the value of an alternating current, in particular of a secondary current, exiting a current source (14), in particular a current transformer, the current indicator (11) comprising:
an electronic circuitry (4) connectable to the current source (14) and supplied by the alternating current,
wherein the electronic circuitry (4) comprises one or more circuitry branches (13) including each at least a switching element (6), said electronic circuitry (4) being configured to deviate a circuit current flowing in the electronic circuitry (4) in said one or more circuitry branches (13) upon activating the switching element (6) based on the value of the alternating current.

2. Current indicator (11) according to claim 1, wherein the electronic circuitry (4) comprises an indication unit (5) for indicating a level of the alternating current.

3. Current indicator (11) according to claim 2, wherein the indication unit (5) comprises at least an indication element (8) formed by at least a light emitting element (7), in particular a light emitting diode.

4. Current indicator (11) according to claim 3, wherein the indication unit (5) comprises a plurality of indication elements (8) connected in parallel.

5. Current indicator (11) according to any one of claims 3 to 4, wherein the electronic circuitry (4) comprises a plurality of circuitry branches (13), at least a part of the switching elements (6) of the circuit branches (13)being configured to allow the passage of the circuit current through one or more light emitting elements (7) connected to said switching elements (6) when said circuit current exceeds a reference threshold current value.

6. Current indicator (11) according to any one of claims 3 to 5, wherein the light emitting element (7) is configured to light up as a function of the circuit current quantity flowing therein.

7. Current indicator (11) according to any one of claims 3 to 6, wherein at least one switching element (6) is configured to deviate the circuit current to the ground when said circuit current exceeds a reference rated current value.

8. Current indicator (11) according to any one of claims 3 to 7, wherein at least one switching element (6) comprises a bipolar transistor or a MOSFET.

9. Current indicator (11) according to any one of the preceding claims, wherein the electronic circuitry (4) further comprises a rectifying unit (9) connectable between the current source (14) and the indication unit (5), wherein the rectifying unit (9) is in particular a diode bridge.

10. Current indicator (11) according to any one of the preceding claims, further comprising a connecting junction 15 to connect the electronic circuit 4 to the current source 14.

11. Current indicator (11) according to any one of the preceding claims, wherein the level of the secondary current displayed by the indication unit (5) is a fraction of a reference rated current value or is equal to said reference rated current value.

12. System (1) comprising:
a current source (14) including an induction module (12) coupable to an electric cable, through which a primary current flows, said induction module (12) being configured to induce a secondary current from said primary current, wherein the primary current is an alternating current; and
a self-powered current indicator (11) according to any one of claims 1 to 11, wherein the current indicator (11) is connectable to the current source (14) for indicating different levels of the value of the primary current flowing in the electric cable, the current indicator (11) being supplied by the secondary current.

13. System (1) according to claim 12, wherein the induction module (12) comprises a magnetic core (2) and a secondary coil (3) coupled to the magnetic core (2), wherein the secondary coil (3) is an output closed circuit.

14. System (1) according to any one of claims 12 to 13, wherein the secondary current ranges from 0 A to a maximum value of 1A.

15. System (1) according to any one of claims 12 to 14, further comprising a digital wireless module for remote communications.
